Europäisches Patentamt

European Patent Office

Office européen des brevets

(19)

(11) **EP 1 235 424 A2**

(12) **EUROPÄISCHE PATENTANMELDUNG**

(43) Veröffentlichungstag:
**28.08.2002 Patentblatt 2002/35**

(51) Int Cl.7: **H04N 3/15**, G02B 21/36

(21) Anmeldenummer: **01128671.3**

(22) Anmeldetag: **01.12.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **24.02.2001 DE 10109130**

(71) Anmelder:
- **Carl Zeiss**
  **89518 Heidenheim (Brenz) (DE)**
  Benannte Vertragsstaaten:
  **DE FR**
- **Carl-Zeiss-Stiftung, trading as Carl Zeiss**
  **89518 Heidenheim (Brenz) (DE)**
  Benannte Vertragsstaaten:
  **GB**

(72) Erfinder: **Cappellaro, Markus**
**81929 München (DE)**

(54) **Verfahren zur Aufzeichung und Darstellung von Fluoreszenzbildern mit hoher räumlicher Auflösung**

(57) Die Erfindung betrifft ein Verfahren zur Aufzeichnung und Darstellung von Fluoreszenzbildern mit hoher räumlicher Auflösung. Es werden mehrere Aufnahmen eines Bildes eines Objektes zeitlich sequentiell mit einer elektronischen Kamera aufgenommen und zwischen den Aufnahmen laterale Verschiebungen zwischen dem Bild des Objektes und der elektronischen Kamera vorgenommen. Die Aufnahmen werden nachfolgend zu einem zusammengesetzten Bild höherer räumlicher Auflösung vereinigt. Vor oder nach der Vereinigung der Teilbilder werden die zu Bildpunkten der Bilder gehörigen Signale, die zu unterschiedlichen Zeiten gewonnen werden, mit Verstärkungsfaktoren verstärkt, die von den Zeitabständen zwischen den betreffenden Bildaufnahmen abhängen und im wesentlichen reziprok zur Zeitabhängigkeit der Fluoreszenz sind. Artefakte durch mit der Zeit abnehmende Fluoreszenzintensitäten (Fading, Bleaching) werden dadurch vermieden.

**FIG.3**

EP 1 235 424 A2

**Beschreibung**

Die Aufnahme von Bildern, insbesondere Fluoreszenzbildern in der Mikroskopie erfolgt heute vielfach mittels digitaler Kameras wie CCD-Kameras. Dafür werden heute Kameras in unterschiedlicher Bauform und mit unterschiedlicher Aufnahmequalität verwendet. Bei der Auswahl einer Kamera stehen die Parameter Aufnahmezeit und Auflösung in der Regel einander gegenüber. Bei hoher Bildrate ist nur eine begrenzte Aufnahmequalität zu erreichen. Hochauflösende digitale Kameras, mit entsprechend höherer örtlicher Auflösung benötigen eine ausreichende Belichtungszeit zur Reduktion des Bildrauschens pro Bildpunkt. Weiter Unterschiede liegen in der Art der Farbaufnahme mit oder ohne Farbteilem und Farbfiltern im Lichtweg und somit sequentieller oder paralleler Aufnahme der Farbkanäle.

Bei der parallelen Aufnahme von Farbbildern mit drei Farbkanälen eines 1-Chip-Sensors besteht das grundsätzliche Problem, daß die eigentlich vorhandene Auflösung des Sensors durch die aufgebrachte Farbmaske mindestens halbiert wird. Dabei befindet sich beispielsweise auf der einen Hälfte der lichtempfindlichen Elemente (Pixel) eine grüne Maske; die andere Hälfte wird zu gleichen Teilen zwischen rot und blau aufgeteilt. Entsprechend reduziert sich die verfügbare Ortsauflösung in den jeweiligen spektralen Kanälen. Um ein Farbbild mit der Basisauflösung des CCD-Sensors zu erzeugen, wird in der Regel bei derartigen Kameras eine mathematische Interpolation zwischen den gemessenen Bildpunkten angewendet.

Durch das in der DE 38 37 063 CI beschriebene Verfahren, dem so genannten "Color-Co-Site-Sampling" Verfahren, gelingt es, den durch die Farbmaske bedingten Auflösungsverlust vollständig zu kompensieren. Dazu wird der CCD-Sensor durch eine hochpräzise Piezomechanik relativ zu dem aufzuzeichnenden Bild derart verschoben, daß nacheinander jeweils an unterschiedlicher Position komplette Teilbilder mit den drei Farbkanälen (R-G-B) aufgezeichnet werden. Durch anschließende Verschachtelung der zeitlich sequentiell aufgezeichneten Teilbilder wird dann ohne Interpolation ein Gesamtbild erstellt. Die Verschiebung erfolgt dabei abhängig von der Farbmaske so, daß ein und der selbe Punkt im Objekt nacheinander von den drei Farbkanälen (z.B. 2x grün, 1x rot und 1x blau) detektiert wird.

Durch ein zusätzliches Microscanning kann die Abtastung eines Bildes in beiden Richtungen um bis zu einem Faktor drei erhöht werden. Entsprechend wird die Anzahl der aufgenommenen Bildpunkte um bis zu einem weiteren Faktor neun gesteigert. eine weitere Steigerung der Abtastung ist wegen der endlichen Appretur nicht sinnvoll.

Die "Microscanning"-Technik zur Steigerung der Auflösung bedingt jedoch , daß ein Bild P aus mehreren nacheinander aufgenommenen Teilbildern $P_n$ zusammengesetzt wird. Somit ist das Verfahren gegenüber Bewegungen des Objekts oder Veränderungen der Leuchtkraft empfindlich. Bei der Aufnahme von Fluorszenzbildern ist die Stabilität der Helligkeit des Objekts ein Problem. Durch die die Fluoreszenz anregende Beleuchtung, erfährt das Präparat eine Ausbleichung, ein sogenanntes "Photo Bleaching" und somit eine Abnahme der Intensität der Fluoreszenz, ein sogenanntes "Fading. Durch die Zusammensetzung der nacheinander aufgenommenen Teilbilder treten dann Artefakte im Gesamtbild auf, die durch die unterschiedlichen Fluoreszenzintensitäten der zeitlich sequentiell aufgenommenen Teilbilder verursacht sind.

Zur Beseitigung von Fading-Artefakten bei der Zusammensetzung zeitlich sequentiell aufgenommener Teilbilder ist es aus der US-A US 5682 567 und US-A 5 682 567 bekannt, die von Bild zu Bild abnehmende Intensität der Fluoreszenz durch eine entsprechende Verlängerung der Aufnahmezeit zu kompensieren. Die dafür erforderliche Korrektur der Belichtungszeit wird dabei jeweils vor der Datenacquisition bestimmt. Die Artefakte im zusammengesetzten Bild werden jedoch nur dann vermieden, wenn die Fluoreszenzintensitäten tatsächlich dem Gesetz gehorcht, das der Berechnung der korrigierten Belichtungszeiten zu Grunde gelegt ist.

Ziel der vorliegenden Erfindung ist es, ein Verfahren zur Aufnahme und Wiedergabe von Fluoreszenzbildern mit hoher räumlicher Auflösung anzugeben, bei dem das Auftreten von Fading-Artefakten vermieden wird.

Dieses Ziel wird durch ein Verfahren mit den Merkmalen des Anspruches 1, ein Fluoreszenzmikroskop mit den Merkmalen des Anspruches 17, ein Computersystem mit den Merkmalen des Anspruches 18 und ein Computerprogramm mit den Merkmalen des Anspruches 19 gelöst. Vorteilhafte Ausführungsformen der Erfindung ergeben sich aus den Merkmalen der abhängigen Ansprüche.

Zur Steigerung der Ortsauflösung werden, wie oben beschrieben, digitale Kameras eingesetzt, mit denen im sogenannten Microscanning-Verfahren eine Mehrfachabtastung durchgeführt wird. Dabei wird entweder durch Ablenken des Kamera-Sensors relativ zum Bild oder durch Ablenken das Strahlengangs relative zum Kamera-Sensor eine Verschiebung des abgetasteten Bilds erreicht. Die zeitlich sequentiell aufgezeichneten Teilbilder werden in der Kamera oder dem angeschlossenen Bildrechner zwischengespeichert und anschließend zu einem Bild mit erhöhter Auflösung verrechnet.

Erfindungsgemäß wird die Durchführung eines Intensitätsausgleichs vor oder nach der Verschachtelung der Meßdaten durchgeführt, mit dem Ziel die Helligkeits- und Farbunterschiede der einzelnen Teilbilder und deren Farbkanäle so auszugleichen, daß eine optimale Kompensation für die Fluoreszenz-Aufnahmen entsteht. Dazu werden die zu den einzelnen Bildpunkten zugehörigen Intensitätssignale mit Verstärkungsfaktoren verstärkt, die von den Zeitabständen zwischen den betreffenden Bildaufnahmen abhängen.

Die Zeitabhängigkeit der Verstärkungsfaktoren ist dabei im wesentlichen reziprok zu der Zeitabhängigkeit der Intensität der Fluoreszenz.

Die Verstärkung der zu den einzelnen Bildpunkten gehörigen Intensitätssignale kann zeitlich vor der Vereinigung der zeitlich sequentiell aufgenommenen Aufnahmen erfolgen. Alternativ ist es möglich, daß die zeitlich sequentiell aufgenommenen Aufnahmen zunächst zu einem Gesamtbild höherer Auflösung zusammengesetzt werden und nachfolgend die zu den Bildpunkten des zusammen gesetzten Bildes gehörigen Signale verstärkt werden.

Die Verstärkungsfaktoren können durch Mittelung der Signale in den einzelnen sequentiell aufgezeichneten Aufnahmen ermittelt werden. Vorteilhaft ist es jedoch, wenn die Verstärkungsfaktoren durch Mittelung der Signale in Teilbereichen der einzelnen sequentiell aufgezeichneten Aufnahmen erfolgt. Die Segmentierung der Teilbilder nach den fluoreszierenden Objekten und die Steuerung der Verstärkungsfaktoren in Abhängigkeit von fluoreszierenden Objekten und Hintergrund liefert eine weitere Verbesserung. Dabei kann die Segmentierung durch einfache Mittel einer Schwellenabfrage zur Unterscheidung von Hintergrundleuchten und fluoreszierenden Objekten erfolgen, aber auch nach aufwendigeren Verfahren wie z.B. in der DE 10017551.1 beschrieben. Besonders bei niedrigem Rauschabstand wird eine weitere Verbesserung erzielt.

Weiterhin ist es möglich, die Verstärkungsfaktoren für die einzelnen sequentiell aufgenommenen Aufnahmen durch Approximation eines an das natürliche zeitliche Abschwächungsverhalten angenäherten Verlaufs der Intensität der zur Fluoreszenz angeregten Stoffe zu ermitteln. Ist das Abklingverhalten der Fluoreszenz des verwendeten Wirkstoffs bekannt und erfolgt die Aufnahme der versetzten Teilbilder in einem festen Zeitraster $\Delta t$, so kann im idealen Fall, diese Vorschrift direkt für die Kompensation des Fading-Effekts und die Bestimmung der Verstärkungsfaktoren genutzt werden. In der Regel werden aber die Parameter der Abklingkurve Schwankungen von Probe zu Probe unterliegen. Eine weitere Verbesserung erhält man jedoch, wenn man die Kenntnis des grundsätzlichen Abklingverhaltens eines Wirkstoffs, z. B. entsprechend der Exponentialfunktion, zur Bestimmung der realen Abklingkurve verwendet und so den Einfluß der statistischen Schwankungen der Meßergebnisse mindert. Aus den mittleren Schwächungswerten der einzelnen Teilmessungen werden durch Approximation die Parameter der idealen Abklingkurve bestimmt.

Bei einer vorteilhaften Ausführungsform werden die einzelnen seitlich sequentiell aufgenommenen Aufnahmen in Bildbereiche segmentiert und die Signale, die zu Bildpunkten unterschiedlicher Bildbereiche gehören, mit unterschiedlichen Verstärkungsfaktoren verstärkt, und die Signale, die zu Bildpunkten des selben Bildbereiches gehören, mit identischen Verstärkungsfaktoren verstärkt werden.

Besonders vorteilhaft ist der Einsatz der Erfindung, wenn als Digitalkamera für die Bildaufnahmen eine Farb-CCD-Kamera eingesetzt wird, da dann aufgrund der relativ langen Belichtungszeiten die Ausbleicheffekte besonders stark sind. Bei Einsatz einer Farbkamera erfolgt dabei die Verschiebung zwischen dem Bild und der Kamera derart, daß ein und der selbe Punkt des Objektes zeitlich sequentiell auf unterschiedliche Farbkanäle des selben CCD-Pixels der Kamera abgebildet wird.

Es kann zweckmäßig sein, für die verschiedenen Farbkanäle unterschiedliche Verstärkungsfaktoren anzuwenden.

Das erfindungsgemäße Verfahren ist besonders vorteilhaft auch bei Mehrfachfluoreszenzen anwendbar, wenn also im abgebildeten Präparat mehrere bei unterschiedlichen Wellenlängen fluoreszierende Stoffe enthalten sind, die simultan durch das verwendete Anregungslicht zur Fluoreszenz angeregt werden. Es können unterschiedliche Verstärkungsfaktoren für die einzelnen Emissionen unter Berücksichtigung der spektralen Empfindlichkeitskurven der Farbkanäle der Kamera ermittelt werden.

Die Ermittlung der Verstärkungsfaktoren für die einzelnen Emissionen kann durch Lösen eines linearen Gleichungssystems erfolgen. Alternativ ist es möglich, für die Ermittlung der Verstärkungsfaktoren für die einzelnen Emissionen Verfahren der Fuzzy Logik oder Verfahren der Neuro-Fuzzy-Logig anzuwenden, also Verfahren, bei denen anstelle von festen Beziehungen in Form von Gleichungen unscharfe Beziehungen in Form von Relationen als Ermittlungskriterien zugrunde gelegt werden.

Die einzelnen Emissionen können dann nachfolgend als Falschfarben dargestellt werden.

Die Erfindung ist vorteilhaft in Verbindung mit einem Fluoreszenzmikroskop mit einem optischen Beleuchtungssystem, einem optischen Abbildungssystem, einem Bildaufnahmesystem und einem Rechnersystem einsetzbar, wobei das Rechnersystem zum Ausführen der betreffenden Korrektur und Überlagerung der Teilbilder ausgebildet ist.

Die Erfindung kann hardwaremäßig oder softwaremäßig in einem Rechner implementiert sein.

Ziel der Erfindung ist es, die Verstärkungsfaktoren für die Farbkanäle der einzelnen Teilbilder so zu bestimmen, daß die Intensität der Farbkanäle über alle Teilbilder nach der Kompensation gleich ist und somit bei der Verschachtelung keine störenden Artefakte entstehen. Dabei ist die Art der Verschachtelung der R-G-B-Sensoren und die Reihenfolge mit der die einzelnen Teilbilder gewonnen werden von untergeordneter Bedeutung. Die Ertfindung ist jedoch auch bei Grauwertbildern anwendbar, indem entsprechend nur ein Kanal pro Teilbild verarbeitet wird.

Wird das Verfahren auf bereits verschachtelte R-G-B-Bilder angewendet, ist jedoch in Kauf zu nehmen, daß bei gegebenen CCD-Arrays häufig jeweils 2 Bildpunkte im grünen Kanal bei der Verschachtelung überlagert werden und somit nicht mehr einzeln getrennt und korrigiert werden können.

Die Kompensation des Intensitätsabfalls durch einfache Verstärkung führt in der Regel zu einer Anhebung des Bildrauschens. Es ist daher zweckmäßig, zusätzlich zum Ausgleich der Helligkeit der einzelnen Teilbildern eine Optimierung des Bildrauschens durchzuführen. Entsprechende Verfahren Verfahren zur adaptiven, rauschoptimierten Filterung sind aus der Literatur, z.B. aus William A. Pratt: Digital Image Processing, 1978, John Wiley & Sons Inc.], New York bekannt.

Nachfolgend wird die Erfindung anhand der Figuren im Detail beschrieben; dabei zeigen:

Figur 1:	ein Mikroskop mit Kamera und Rechnersystem zur Ausführung der Erfindung in der Fluoreszenzmikroskopie;

Figur 2a:	eine schematische Darstellung von CCD-Arrays mit einer Anordnung der Farbmaske und dem Laufweg zur Aufnahme von Teilbildern,

Figur 2b:	eine schematische Darstellung der Abtastung im Co-Site-Sampling-Verfahren mit zusätzlich dreifacher Auflösung,

Figur 3:	ein Blockschaltbild für die Verschachtelung von Teilbildern;

Figur 4 :	ein Diagramm des Abfalls der Intensität während eines Microscanns;

Figur 5:	ein Diagramm für die Approximation der gemessenen Intensitäten durch eine Exponentialfunktion;

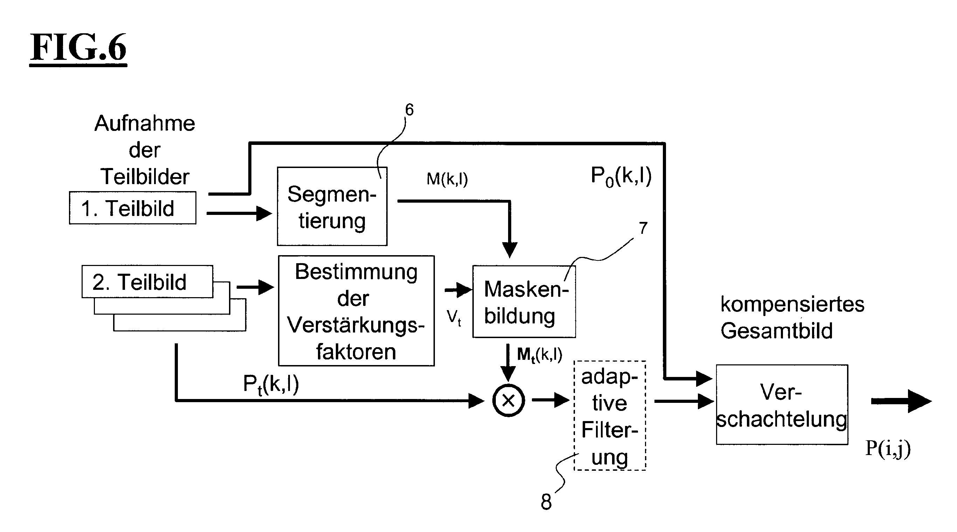

Figur 6:	ein Blockschaltbild einer erweiterten Fading-Kompensation;

Figur 7:	Segmentierte Bildbereiche;

Figur 8:	Selektionskurven der Farbkanäle, und

Figur 9:	ein Blockschaltbild eine Ausschnitts eines Rechenwerkes zur Kanaltrennung

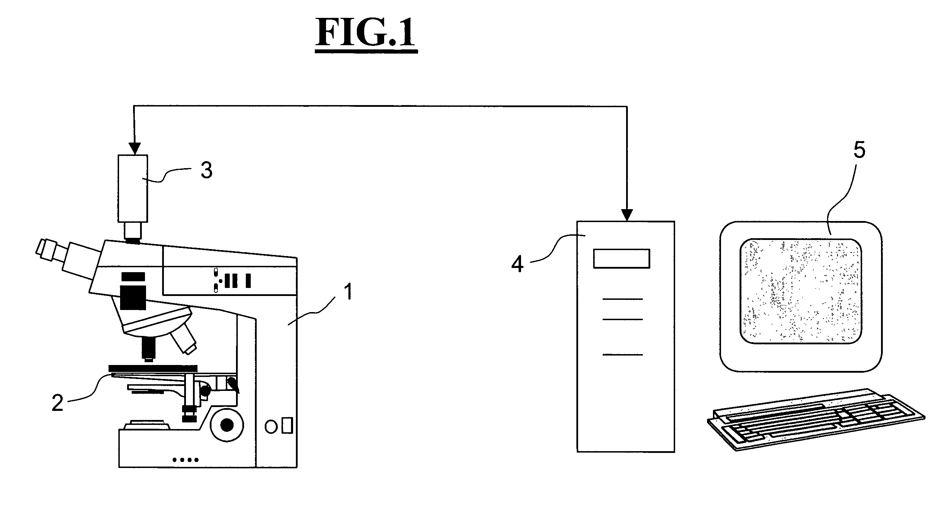

Das in der Figur 1 dargestellte System besteht aus einem Mikroskop (1) mit einem motorisch verstellbaren Präparattisch (2), einer Videokamera (3) und einem Bildverarbeitungsrechner (4) mit einem daran angeschlossenen Monitor (5), der zur Bilddarstellung dient.

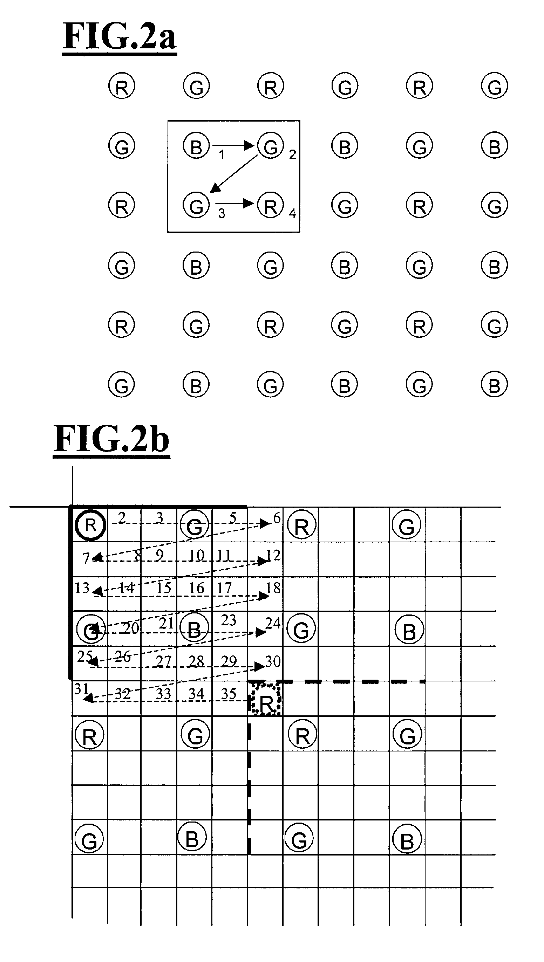

Die Erzeugung von Farbbildern ohne zusätzliche Interpolation erfolgt nach dem Color-Co-Site-Verfahren mit einer Farbmaske entsprechend Figur 2a. Dort sind mit R, G und B die rot-, grün- und blauempfindlichen Farbpixel angedeutet. Für das Color-Co-Site-Verfahren werden vier Einzelbilder benötigt, die durch eine Verschiebung des Aufnahmesystems relativ zum aufzunehmenden Bild - oder des aufzunehmenden Bildes relativ zum Aufnahmesystem - in vier nacheinander folgenden Schritten um jeweils einen Rasterpunkt in x - und y-Richtung, entsprechend dem Laufweg — 1-2-3-4- aufgenommen werden. Daraus resultiert eine Vervielfachung um $m_c$ x $n_c$ = 2 x 2 = 4 Teilbilder.

Zur Aufnahme von mikroskopischen Bildern mit hoher Auflösung wird zusätzlich das sogenannte "Microscanning"-Verfahren zur Erhöhung der Dichte der Bildabtastung und damit der Auflösung des Bildsystems eingesetzt. Dabei wird durch die relative Versetzung von CCD-Sensor und Strahlengang der mikroskopischen Abbildung, also eine Versetzung der abgebildeten Objektdetails relativ zur Sensorfläche des CCD-Sensors zwischen den Teilbildern eine Mehrfachabtastung des Objekts erzielt. Allgemein erhält man aus $m_r$ x $n_r$ Einzelbildern $P_t(x,y)$ das hochaufgelöste Überlagerungsbild P(x,y), wobei die laterale Auflösung im zusammengesetzten Bild dem mr- bzw. $n_r$-fachen der lateralen Auflösung der Einzelbilder entspricht.

Zur Verdeutlichung ist ein möglicher Ablauf der Verschiebungen bei dreifacher Auflösung und gleichzeitiger Anwendung des Color-Co-Site-Verfahrens in Figur 2b dargestellt. Das Gitter stellt das über das Bild gelegte Abtastraster dar. Der verstärkt gezeichnete Schenkel bezeichnet eine Ecke des CCD-Arrays mit der dort angeordneten rotempfindlichen CCD-Zelle. Das Array wird in 6x6 Schritten jeweils um ein Rasterfeld des Abtastrasters relativ zum Bild verschoben und in 36 einzelnen Datensätzen, die jedes ein Teilbild darstellen, ausgelesen. Um eine fehlerfreie Überlagerung der zeitlich nacheinander gewonnenen Teilbilder zu erhalten, dürfen sich die Objektdetails relativ zueinander während der gesamten Aufhahmezeit der Serie der Teilbilder nicht bewegen.

Eine Veränderung der Intensität ergibt sich aber zwangsläufig bei der Aufnahme von Fluoreszenz-Bildern. Die Leuchtkraft der emittierenden Bereiche bleicht mit der Zeit aus. So wird zum Beispiel bei der Aufnahme von mit dem Marker "Oregon Green 488" angeregten Zellen , die Intensität der Fluoreszenz in der Aufnahmezeit von 20 sec um 50% geschwächt. Die Schwächung hängt dabei von den jeweiligen Randbedingungen — Lichtintensität, freie Radikale, u.s.w. - ab. Fügt man die einzelnen Teilbilder entsprechend der versetzten Abtastung zu einem Gesamtbild zusammen, so erhält man aufgrund der unterschiedlichen Indensitäten Artefakte im Bild. Bei einer Auslesefolge nach benachbarten Elementen in der Zeile und anschließend benachbarten Zeilen, treten bevorzugt Artefakte in Zeilenrichtung, in der Regel helle und dunkle aufeinander folgende Bildstreifen in Zeilenrichtung, auf.

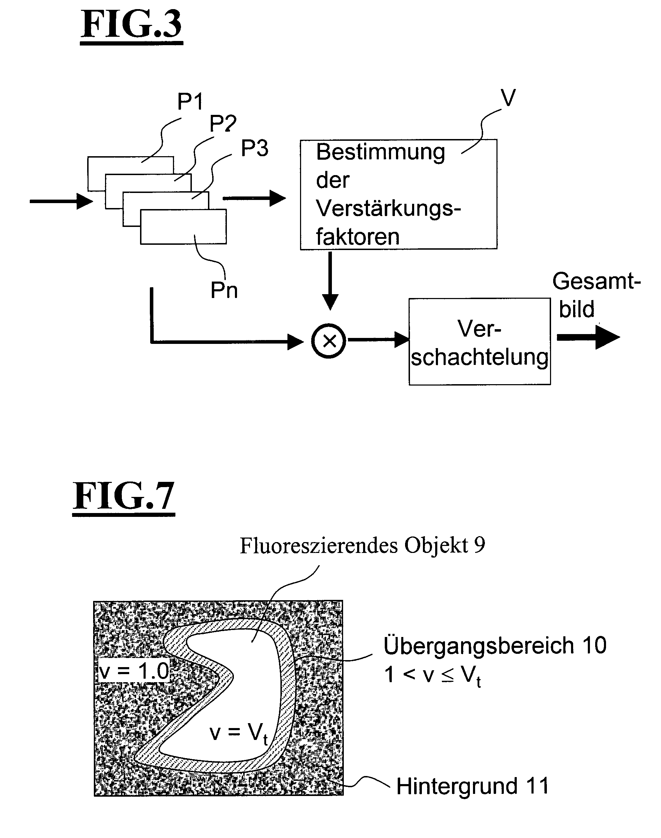

Durch das erfindungsgemäße Verfahren zur Kompensation der Intensitätsunterschiede bei abklingender Fluoreszenz wird die Darstellung eines artefaktfreien Fluoreszenzbildes in hoher Bildgüte möglich. Wie in der Figur 3 dargestellt werden die Intensitätswerte der einzelnen Teilbilder (P1, P2, ...Pn) vor oder nach der Verschachtelung mit Verstärkungsfaktoren (V) multipliziert.

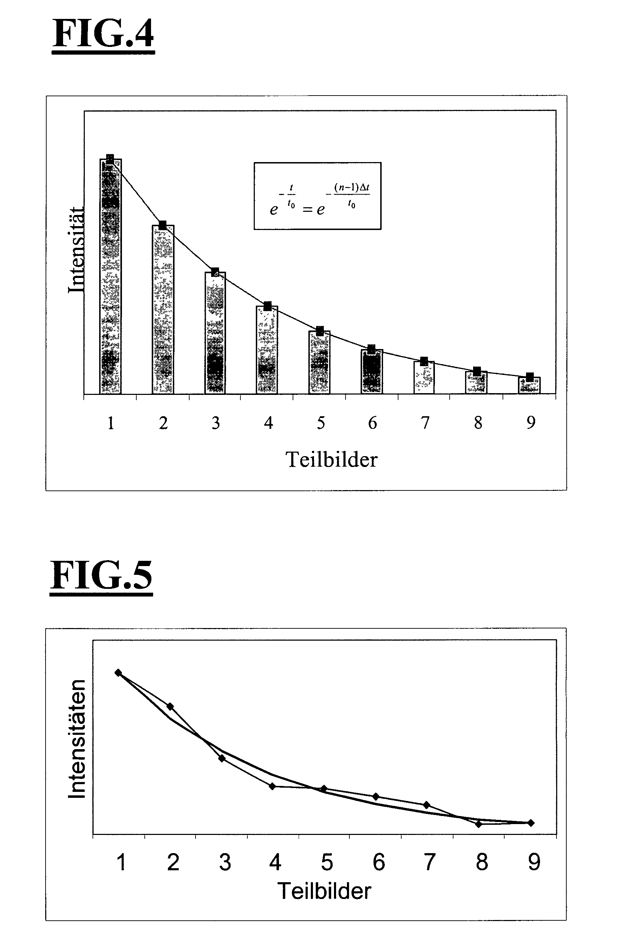

Bei einer Fluoreszenzaufnahme ist die Intensität des emittierten Lichts proportional der Menge der Fluorophor-Konzentration. Da die Anzahl der Leuchtkörper in der Regel entsprechend einer Exponentialfunktion abnehmen, nimmt auch die Intensität des Bildes entsprechend einer Exponentialfunktion ab. Dies ist in Figur 4 für neun Teilbilder beispielsweise dargestellt. Die Halbwertszeiten bzw. die Schwächungskonstante $1/t_0$ für verschiedenen Wirkstoffe, auch Marker genannt, sind in der Regel bekannt oder können durch Messung bestimmt werden.

Für die Intensitäten $I_t$ eines Objektes zum Zeitpunkt t gilt mit der Anfangsintensität $I_0$

$$I_t = I_o e^{-\frac{t}{t_0}} \qquad\qquad\qquad \text{Gl. (1)}$$

und für die Bildpunkte des Teilbildes, gemessen zur Zeit t ergibt sich

$$P_t(x,y) = P_0(x,\ y)\ e^{-\frac{t}{t_0}}. \qquad\qquad\qquad \text{Gl. (2)}$$

Ist die Schwächungskonstante bekannt, so kann man die Abschwächung der einzelnen Teilbilder durch die Verstärkung $V_t$ kompensieren,

$$V_t = e^{\frac{t}{t_0}}. \qquad\qquad\qquad \text{Gl. (3)}$$

Für das einzelne kompensierte Teilbild erhält man somit

$$\widetilde{P}_t(x,y) = V_t\ P_t(x,y) \qquad\qquad\qquad \text{Gl. (4)}$$

bzw. für diskrete Bildpunkte k,1

$$\widetilde{P}_t(k,l) = V_t\ P_t(k,l) \qquad\qquad\qquad \text{Gl. (4a)}$$

Bei einer Steigerung der Auflösung um den Faktor $m_r$ in x-Richtung und $n_r$ in y-Richtung erhält man bei der Verschachtelung von insgesamt m * n Teilbildern der Größe K * L ein Gesamtbild der Größe M * N

$$M = m\,K = m_c\,m_r\,K \ und\ N = n\,K = n_c\,n_r\,L$$

und für die diskreten Bildpunkte i,j erhält man

$$P(i,j) = \sum_{m,n} \widetilde{P}_{t\nu\mu}(k,l) \qquad mit \quad i = m\,(k-1)+\mu,$$

$$j = n\,(l-1)+\nu\,;$$

$$oder \qquad\qquad\qquad \text{Gl. (5)}$$

$$k = \left\lfloor \frac{i-1}{m} \right\rfloor_{floor} + 1, \qquad \mu = i - m\,(k-1),$$

$$l = \left\lfloor \frac{j-1}{n} \right\rfloor_{floor} + 1, \qquad \nu = j - n\,(l-1);$$

Liegt die Abschwächungskonstante nicht explizit vor, so kann diese nach verschiedenen Verfahren näherungsweise aus den gemessenen Daten der Teilbilder bestimmt werden. Beispiele hierfür sind:

Mittelwert der Teilbilder

Unter der Annahme, daß die Intensität der drei Farbkanäle R,G,B, nach dem gleichen Schwächungsgesetz und mit gleicher Schwächungskonstante $1/t_0$ abfallen, kann man die Intensität eines Bildes als den Mittelwert über alle n Bildpunkte bestimmen

$$I_t = \overline{P}_t = \frac{1}{n} \sum_n P_t(k,l) \qquad \text{Gl. (6)}$$

Entsprechend kann die Intensität für die einzelnen Farbkanäle R(k,l), G(k,l) und B(k,l) und Pixel (k,l) bestimmt werden

$$I_{Rt} = \overline{R}_t = \frac{1}{n} \sum_n R_t(k,l)$$

$$I_{Gt} = \overline{G}_t = \frac{1}{n} \sum_n G_t(k,l) \qquad \text{Gl. (6a)}$$

$$I_{Bt} = \overline{B}_t = \frac{1}{n} \sum_n B_t(k,l)$$

Bei gleichem Abklingverhalten für alle Farbkanäle können die Quotienten aus der Intensität eines Farbkanals zur Zeit t und der Anfangsintensität des Farbkanals zur Zeit $t_0$ summiert und aus der Summe der Verstärkungsfaktor gebildet werden

$$V_t = 3 \left( \frac{\overline{R}_t}{\overline{R}_0} + \frac{\overline{G}_t}{\overline{G}_0} + \frac{\overline{B}_t}{\overline{B}_0} \right)^{-1} \qquad \text{Gl. (7)}$$

Durch die Summierung der Abschwächungen der einzelnen Farbkanäle wird der Verstärkungsfaktor mit einer höheren statistischen Sicherheit bestimmt.

Bestimmung des mittleren Schwächungskoeffizienten

Entsprechend der Formel Gl.(6) werden die Intensitäten der einzelnen Teilbilder und hieraus die Schwächungswerte $I_t/I_0$ als Quotient aus der Intensität zur Zeit t und der Intensität zur Zeit $t_0$ berechnet. Geht man von eine Abschwächung nach der Exponentialfunktion aus, so kann man die Reihe der Schwächungswerte der einzelnen Teilbilder durch die e-Funktion, entsprechend Gl.(1) approximieren und die Konstante $t_0$ so bestimmt ("fitten"), daß die gemessenen Schwächungswerte möglichst gut angenähert werden (Figur 5). Entsprechende Verfahren zur Approximation sind aus der Literatur bekannt. Die Kompensation der Abschwächungen erfolgt dann nach dem oben beschriebenen Verfahren entsprechend Gl. (4).

Bestimmung des Schwächungskoeffizienten durch Segmentierung der fluoreszierenden Objekte

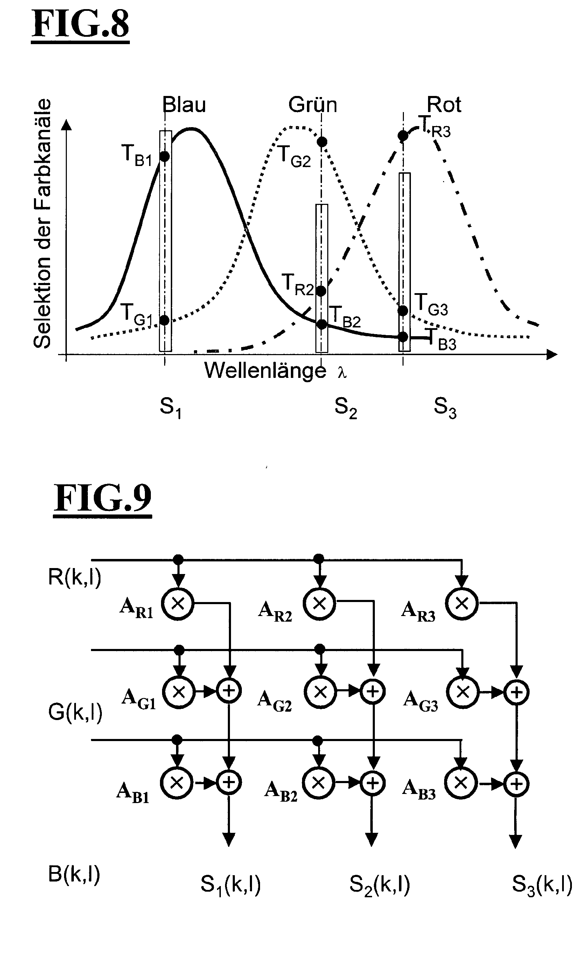

Bei fluoreszierenden Objekten schwächt sich die Intensität im wesentlichen innerhalb des Objektes selbst mit der Zeit ab. Die Intensität des Hintergrundes bleibt dagegen relativ konstant. Durch eine globale Kompensation mit einem einheitlichen Verstärkungsfaktor für das gesamte Bild können im Bildhintergrund neue Artefakte erzeugt werden, da auch die Intensität des Bildhintergrundes bei der Ermittlung der Abschwächung und des Verstärkungsfaktors zugrunde gelegt wird. Eine weitere Verbesserung der Kompensation kann erreicht werden, wenn in einem Teilbild die fluoreszierenden Objekte in einem vorgelagerten Segmentierungsschritt (6), siehe Figur 7, segmentiert werden und in einem nachfolgenden Maskierungsschritt (7) eine Maske der segmentierten Bildbereiche gebildet wird. Mit Hilfe der gebildeten Maske werden dann auch aus den nachfolgenden Teilbildern nur diejenigen Bildbereiche für die Ermittlung der Verstärkungsfaktoren $V_t$ zur Kompensation der Abschwächung herangezogen, die den segmentierten Bereichen des ersten Teilbildes entsprechen. Entsprechend werden dann bei der nachfolgenden Verschachtelung der Teilbilder auch nur die Intensitäten in den maskierten Bildbereichen entsprechend verstärkt, während für den Bildhintergrund ein Verstärkungsfaktor V = 1.0 verwendet wird. Eine Bestimmung von lokal abhängigen Verstärkungsfaktoren für den Hintergrund ist natürlich auch möglich.

Die Segmentierung kann zum Beispiel durch eine einfache Schwellwertabfrage erfolgen. In der Regel wird man jedoch Verfahren unter Verwendung von lokalen Mittelwerten und lokaler Varianz verwenden . Derartige Verfahren sind beispielsweise in Bernd Jähne, et. al.: Handbook of Computer Vision and Applications, 1999, Academic Press, London beschrieben. Eine besonders hohe Sicherheit in der Bestimmung der Objektgrenzen läßt sich mit den in der DE 10017551.1 vorgeschlagenen Methoden erzielen.

Grundsätzlich kann die Segmentierung für jedes gemessene Teilbild durchgeführt werden. Es ist aber ausreichend, nur anhand des ersten Teilbildes eine Segmentierung durchzuführen und eine Objektmaske **M**(k,l) zur Kennzeichnung der Objekte zu erzeugen und diese für alle weiteren Auswertungen und Berechnungen der Verstärkungsfaktoren zu nutzen. Die Kompensation kann ebenfalls auf die segmentierten Objekte beschränkt bleiben. Um jedoch zusätzliche Artefakte an den Objektgrenzen zu vermeiden, ist es vorteilhaft, entlang der Objektränder einen Übergangsbereich einzufügen, in dem die Verstärkung von 1 auf $V_t$ ansteigt, wie dieses in Figur 7 dargestellt ist. Die Objektmaske **M**(k,l) wird dabei in die Verstärkungsmatrix $\mathbf{M}_t$(k,l) übergeführt. Für das kompensierte Teilbild erhält man

$$\widetilde{P}_t(k,l) = \mathbf{M}_t(k,l) \circ P_t(k,l) \qquad \text{Gl. (8)}$$

das Zeichen $\circ$ wird hier für eine Multiplikation der einzelnen Elemente der Matrizen bzw. des Bildes benutzt

Bei der Kompensation der abgeschwächten Emission in den einzelnen Teilbildern wird das gesamte Teibild oder ein Teilbereich des Bildes verstärkt. Mit der Verstärkung der Objekte wird gleichzeitig das Bild-Rauschen der kompensierten Teilbilder angehoben. Dies führt zu einem verstärkten Rauschen im verschachtelten Gesamtbild. Durch die Einführung einer zusätzlichen Verarbeitungsstufe mit adaptiven Bildfilterung (8), zum Beispiel nach der Optimalfiltermethode, und zusätzlicher Steuerung des adaptiven Filter durch den Verstärkungsfaktor $V_t$ kann das durch die vorausgehenden Verfahrensschritte erhöhte Bildrauschen wiederum kompensiert werden. Die hier zur Anwendung kommenden Verfahren zur adaptiven Filterung sind aus der Literatur bekannt und beispielsweise in William A. Pratt: Digital Image Processing, 1978, John Wiley & Sons Inc.], NewYork beschrieben.

Multikanal-Fluoreszenz

Das Verfahren läßt sich auch auf eine gleichzeitige Multikanal-Fluoreszenz erweitern. Regt man das Objekt mit bis zu drei Markern an, die Licht in unterschiedlicher Wellenlänge emittieren, so ist es möglich maximal drei Fluoreszenz-Kanäle zu unterscheiden und automatisch zu separieren. Voraussetzung dafür ist jedoch, daß mehrere Emissionssignale nicht ausschließlich oder vorwiegend in einen Farbkanal fallen. Mit anderen Worten, bei drei unterschiedlichen Markern sollten die Emissionsschwerpunkte möglichst über alle drei Farbkanäle verteilt sein. Weiter wird davon ausgegangen, daß die spektralen Empfindlichkeitskurven der einzelnen Farbkanäle in Abhängigkeit von der Wellenlänge bekannt sind. In Figur 8 sind die spektralen Empfindlichkeitskurven der einzelnen Farbkanäle - Blau, Grün, Rot - eines Aufnahmesystems schematisch dargestellt. Die in das Diagramm eingezeichneten Signale $S_1$ bis $S_3$, z.B. die Fluorszenzlinien dreier Marker 1, 2, 3, tragen mit den Transmissionskoeffizienten $T_{xn}$ zu den Farbkanälen bei. Dabei bezeichnet x den Farbkanal R, G ,B und n die Nummer des Signals oder Markers. Somit erhält man zum Beispiel für die Intensität des roten Kanals R(k,l)

$$R(k,l) = T_{R1}\, S_1(k,l) + T_{R2}\, S_2(k,l) + T_{R3}\, S_3(k,l) \qquad \text{Gl. (9)}$$

Eine entsprechende Summe der Anteile ergibt sich für die Intensität des grünen Kanals G(k,l) und die Intensität des blauen Kanals B(k,l). Die Gleichungen lassen sich mit der Transmissionsmatrix T vereinfacht als Matrix-Gleichung schreiben

Mit

$$T = \begin{pmatrix} T_{R1} & T_{R2} & T_{R3} \\ T_{G1} & T_{G2} & T_{G3} \\ T_{B1} & T_{B2} & T_{B3} \end{pmatrix} \qquad \text{Gl. (10)}$$

ergibt sich

$$\begin{pmatrix} R(k,l) \\ G(k,l) \\ B(k,l) \end{pmatrix} = \begin{pmatrix} T_{R1} & T_{R2} & T_{R3} \\ T_{G1} & T_{G2} & T_{G3} \\ T_{B1} & T_{B2} & T_{B3} \end{pmatrix} \begin{pmatrix} S_1(k,l) \\ S_2(k,l) \\ S_3(k,l) \end{pmatrix} \qquad \text{Gl. (10a)}$$

Löst man das Gleichungssystem auf, so erhält man die Intensitäten $S_1(k,l)$, $S_2(k,l)$ und $S_3(k,l)$ der einzelnen Signale für jeden Bildpunkt k,l

$$S_n = \frac{|T_n|}{|T|} \qquad \text{Gl. (11)}$$

dabei ist |T| die Determinante der Matrix **T** und $|'T_n|$ die Determinante, die durch Ersetzen der n-ten Spalte in der Matrix **T** mit dem Vektor {R G B} entsteht;

$$S_1 = \frac{\begin{vmatrix} R & T_{R2} & T_{R3} \\ G & T_{G2} & T_{G3} \\ B & T_{B2} & T_{B3} \end{vmatrix}}{\begin{vmatrix} T_{R1} & T_{R2} & T_{R3} \\ T_{G1} & T_{G2} & T_{G3} \\ T_{B1} & T_{B2} & T_{B3} \end{vmatrix}} \quad S_2 = \frac{\begin{vmatrix} T_{R1} & R & T_{R3} \\ T_{G1} & G & T_{G3} \\ T_{B1} & B & T_{B3} \end{vmatrix}}{\begin{vmatrix} T_{R1} & T_{R2} & T_{R3} \\ T_{G1} & T_{G2} & T_{G3} \\ T_{B1} & T_{B2} & T_{B3} \end{vmatrix}} \quad S_3 = \frac{\begin{vmatrix} T_{R1} & T_{R2} & R \\ T_{G1} & T_{G2} & G \\ T_{B1} & T_{B2} & B \end{vmatrix}}{\begin{vmatrix} T_{R1} & T_{R2} & T_{R3} \\ T_{G1} & T_{G2} & T_{G3} \\ T_{B1} & T_{B2} & T_{B3} \end{vmatrix}} \qquad \text{Gl. (12)}$$

dabei sind $S_1$, $S_2$, $S_3$ und R, G, B Funktionen von (k,l)
Die Ergebnisse der Gl( 12) lassen sich zusammenfassen

$$S_1(k,l) = A_{R1} R(k,l) + A_{G1}\, G(k,l) + A_{B1}\, B(k,l);$$

$$S_2(k,l) = A_{R2}\, R(k,l) + A_{G2}\, G(k,l) + A_{B2}\, B(k,l);$$

$$S_3(k,l) = A_{R3}\, R(k,l) + A_{G3}\, G(k,l) + A_{B3}\, B(k,l); \qquad \text{Gl. (13)}$$

Das Farbbild läßt sich somit in die Abbildungen der drei emittierenden Signale trennen. Den einzelnen Signalen können dann Grauwerte oder Falschfarben zugeordnet werden. Es sei nochmals darauf hingewiesen, daß für eine gute Trennung der Signale die einzelnen Signale frequenzmäßig nicht zu nahe beieinander liegen sollen und einzelne Transmissionskoeffizienten nicht beliebig klein werden sollen. Die Gleichungen lassen sich für zwei unterschiedliche Marker entsprechend vereinfachen.
Zur Kompensation des Fading-Effekts sind die zu unterschiedlichen Zeiten gemessenen Teilbilder jeweils nach Gl. (13) in die Signale $S_{1t}$, $S_{2t}$, $S_{3t}$ aufzutrennen. Die Berechnung der Kompensation der einzelnen Signale erfolgt dann entsprechend den oben angegebenen Verfahren für jedes fluoreszierende Signal getrennt. Entsprechend werden die Verfahren zur Bestimmung der Verstärkungsfaktoren auf die einzelnen Signale bzw. deren Bilder angewandt.

Die Realisierung der angegebenen Beziehungen ist mit speziellen Rechenwerken der Signalverarbeitung möglich. Speziell für die Trennung der einzelnen Emissionssignale läßt sich, wie in Figur 9 dargestellt, ein einfaches Rechenwerk angeben, bei dem im Pipelineverfahren alle Rechenoperationen parallel ablaufen können. Ein solcher Pipelinerechner enthält 9 Multiplikationsstufen und 6 Additionsstufen. Entsprechende Schaltungen sind für die übrigen Rechenschritte angebbar. Die Realisierung aller Funktionen ist aber ebenfalls mit handelsüblichen Signalprozessoren oder auf einem Arbeitsrechner (PC) über eine entsprechende Software möglich.

Neben der Lösung des angegebenen linearen Gleichungssystems kann bei stark verrauschten Signalen die Trennung der einzelnen Fluoreszenz-Kanäle auch nach dem Prinzip eines "Fuzzy-Verfahrens" oder "NeuroFuzzy-Verfahrens" erfolgen. In diesem Fall werden dann für die Trennung der Beiträge der einzelnen Marker zu den Gesamtintensitäten der einzelnen Farbkanäle keine linearen Gleichungen zugrunde gelegt sondern Ungleichungen oder Relationen, anhand derer Näherungswerte für die Intensitäten der einzelnen Marker abgeschätzt werden.

**Patentansprüche**

1. Verfahren zur Aufzeichnung und Darstellung von Fluoreszenzbildern mit hoher räumlicher Auflösung, bei dem mehrere Aufnahmen eines Bildes eines Objektes zeitlich sequentiell mit einer elektronischen Kamera aufgenommen werden und zwischen den Aufnahmen laterale Verschiebungen zwischen dem Bild des Objektes und der elektronischen Kamera vorgenommen werden, und wobei die Aufnahmen zu einem zusammengesetzten Bild höherer räumlicher Auflösung vereinigt werden, **dadurch gekennzeichnet, daß** die zu Bildpunkten der Bilder gehörigen Signale, die zu unterschiedlichen Zeiten gewonnen werden, mit Verstärkungsfaktoren verstärkt werden, die von den Zeitabständen zwischen den betreffenden Bildaufnahmen abhängen.

2. Verfahren nach Anspruch 1, wobei die Zeitabhängigkeit der Verstärkungsfaktoren im wesentlichen reziprok zu der Zeitabhängigkeit der Intensität der Fluoreszenz ist.

3. Verfahren nach Anspruch 1 oder 2, wobei die Verstärkung der Signale vor der Vereinigung der zeitlich sequentiell aufgenommenen Aufnahmen erfolgt.

4. Verfahren nach Anspruch 1 oder 2, wobei die zeitlich sequentiell aufgenommenen Aufnahmen zunächst zu einem Gesamtbild höherer Auflösung zusammengesetzt werden und nachfolgend die zu den Bildpunkten des zusammen gesetzten Bildes gehörigen Signale verstärkt werden.

5. Verfahren nach einem der Ansprüche 1 bis 4, wobei die Verstärkungsfaktoren durch Mittelung der Signale in den einzelnen sequentiell aufgezeichneten Aufnahmen bestimmt werden.

6. Verfahren nach einem der Ansprüche 1 bis 4, wobei die Verstärkungsfaktoren durch Mittelung der Signale in Teilbereichen der einzelnen sequentiell aufgezeichneten Aufnahmen bestimmt werden.

7. Verfahren nach einem der Ansprüche 1 bis 4, wobei die Verstärkungsfaktoren für die einzelnen sequentiell aufgenommenen Aufnahmen durch Approximation eines an das natürliche zeitliche Abschwächungsverhalten angenäherten Verlaufs der Intensität der zur Fluoreszenz angeregten Stoffe bestimmt werden.

8. Verfahren nach einem der Ansprüche 1 bis 7, wobei eine adaptive Bildfilterung des zusammengesetzten Bildes zur Unterdrückung von Rauschen erfolgt.

9. Verfahren nach Anspruch 6, wobei die einzelnen seitlich sequentiell aufgenommenen Aufnahmen in Bildbereiche segmentiert werden und die Signale, die zu Bildpunkten unterschiedlicher Bildbereiche gehören, mit unterschiedlichen Verstärkungsfaktoren verstärkt, und die Signale, die zu Bildpunkten des selben Bildbereiches gehören, mit identischen Verstärkungsfaktoren verstärkt werden.

10. Verfahren nach einem der Ansprüche 1 bis 9, wobei für die Bildaufnahmen eine Farb-CCD-Kamera eingesetzt wird.

11. Verfahren nach Anspruch 10, wobei die Verschiebung zwischen dem Bild und der Kamera derart erfolgt, daß ein und der selbe Punkt des Objektes zeitlich sequentiell auf unterschiedliche Farbkanäle des selben CCD-Pixels der Kamera abgebildet wird.

12. Verfahren nach Anspruch 11, wobei für die verschiedenen Farbkanäle unterschiedliche Verstärkungsfaktoren verwendet werden.

13. Verfahren nach Anspruch 10, bei dem gleichzeitig mehrere Fluoreszenz-Emissionen angeregt werden und unterschiedliche Verstärkungsfaktoren für die einzelnen Emissionen unter Berücksichtigung der spektralen Empfindlichkeitskurven der Farbkanäle ermittelt werden.

14. Verfahren nach Anspruch 13, bei dem die Ermittlung der Verstärkungsfaktoren für die einzelnen Emissionen durch Lösen eines linearen Gleichungssystems erfolgt.

15. Verfahren nach Anspruch 13, bei dem die Ermittlung der Verstärkungsfaktoren für die einzelnen Emissionen durch ein Verfahren der Fuzzy Logig oder ein Verfahren der Neuro-Fuzzy-Logig erfolgt.

16. Verfahren nach einem der Ansprüche 13 - 15, bei dem die einzelnen Emissionen als Falschfarben dargestellt werden.

17. Fluoreszenzmikroskop mit einem optischen Beleuchtungssystem, einem optischen Abbildungssystem, einem Bildaufnahmesystem und einem Rechnersystem, wobei das Rechnersystem zum Ausführen eines Verfahrens nach einem der Ansprüche 1 bis 16 ausgebildet ist.

18. Computersystem, das zur Ausführung eines Verfahrens nach einem der Ansprüche 1 bis 16 geeignet ist.

19. Computerprogrammprodukt, das in den Speicher eines digitalen Computers ladbar ist und einen Softwarecode zur Durchführung eines Verfahrens mit den Schritten nach einem der Ansprüche 1 bis 16 aufweist, wenn das Programm auf dem Computer abläuft.

# FIG.1

# FIG.2a

# FIG.2b

# FIG.3

# FIG.7

Fluoreszierendes Objekt 9

$v = 1.0$

$v = V_t$

Übergangsbereich 10
$1 < v \leq V_t$

Hintergrund 11

## FIG.4

$$e^{-\frac{t}{t_0}} = e^{-\frac{(n-1)\Delta t}{t_0}}$$

Intensität

1 2 3 4 5 6 7 8 9

Teilbilder

## FIG.5

Intensitäten

1 2 3 4 5 6 7 8 9

Teilbilder

# FIG.6

EP 1 235 424 A2

Aufnahme der Teilbilder

1. Teilbild

2. Teilbild

Segmen-tierung — 6

Bestimmung der Verstärkungs-faktoren

$M(k,l)$

$V_t$

Masken-bildung — 7

$P_0(k,l)$

$M_t(k,l)$

$P_t(k,l)$

$\otimes$

adap-tive Filter-ung — 8

kompensiertes Gesamtbild

Ver-schachtelung

$P(i,j)$

# FIG.8

# FIG.9